Europäisches Patentamt

European Patent Office

Office européen des brevets

(11) Veröffentlichungsnummer: **0 669 406 A2**

## EUROPÄISCHE PATENTANMELDUNG

(21) Anmeldenummer: **95101041.2**

(22) Anmeldetag: **26.01.95**

(51) Int. Cl.6: **C23C 14/34**, C23C 14/56, C23C 14/06, C23C 14/18, D01F 11/12, C04B 41/50, C22C 1/09

(30) Priorität: **28.01.94 DE 4402471**
**23.02.94 DE 4405854**

(43) Veröffentlichungstag der Anmeldung:
**30.08.95 Patentblatt 95/35**

(84) Benannte Vertragsstaaten:
**DE FR GB**

(71) Anmelder: **DEUTSCHE FORSCHUNGSANSTALT FÜR LUFT- UND RAUMFAHRT e.V.**
**Linderhöhe**
**D-51147 Köln (DE)**

(72) Erfinder: **Leucht, Rolf, Dipl.-Ing.**
**Saturnstrasse 13**
**D-53842 Troisdorf (DE)**

Erfinder: **Weber, Klaus, Dipl.-Ing.**
**Hansaring 12**
**D-50670 Köln (DE)**
Erfinder: **Dudek, Hans J., Dr.**
**Auf dem Kamp 19**
**D-53779 Hennef-Rott (DE)**
Erfinder: **Wei, William, Dr.**
**Parzivalstrasse 6**
**D-80804 München (DE)**

(74) Vertreter: **Hilleringmann, Jochen, Dipl.-Ing. et al**
**Patentanwälte**
**von Kreisler-Selting-Werner,**
**Bahnhofsvorplatz 1 (Deichmannhaus)**
**D-50667 Köln (DE)**

(54) **Vorrichtung und Verfahren zum Beschichten von mindestens eine Einzelfaser aufweisendem Fasermedium sowie beschichtetes Fasermedium für faserverstärkte Bauteile.**

(57) Die Vorrichtung zum Beschichten von mindestens eine Einzelfaser aufweisendem Fasermedium ist mit einer Trägervorrichtung zum Halten des zu beschichtenden mindestens eine Einzelfaser aufweisenden Fasermediums und mit einer Sputtervorrichtung mit mehreren Beschichtungszonen zum Aufbringen von Beschichtungsmaterialien versehen. Eine Transportvorrichtung dient zum Transportieren des Fasermediums entlang eines Transportweges durch die Beschichtungszonen der Sputtervorrichtung zwecks sukzessivem Aufbringen mehrerer Lagen aus unterschiedlichem Beschichtungsmaterial auf das Fasermedium.

FIG.4

EP 0 669 406 A2

Die Erfindung betrifft eine Vorrichtung und ein Verfahren zum Beschichten von mindestens eine Einzelfaser aufweisendem Fasermedium sowie beschichtetes Fasermedium für faserverstärkte Bauteile. Insbesondere befaßt sich die Erfindung mit einer Vorrichtung und einem Verfahren zum kontinuierlichen Aufbringen einer Vielzahl von Schichten aus unterschiedlichen Beschichtungsmaterialien auf eine Lang- bzw. Endlosfaser. Im Rahmen dieser Erfindung soll mit dem Begriff "Fasermedium" ("Langfasermedium") sowohl eine Einzelfaser (Endlos-Einzelfaser), als auch ein Faserbündel aus mehreren Einzelfasern (Endlos-Einzelfasern) als auch ein Faserband aus mehreren parallel zueinander verlaufenden und im Abstand zueinander angeordneten Einzelfasern (Endlos-Einzelfasern) gemeint sein.

Faserverstärkte Verbundwerkstoffe können ihren Anforderungen als Hochleistungswerkstoffe nur erfüllen, wenn deren mikrostruktureller Aufbau, je nach Anwendung, unterschiedliche Aufgaben übernimmt. Zu den wichtigsten Aufgaben des mikrostrukturellen Aufbaus zählen unter anderem dabei die Stabilisierung der Grenzfläche zwischen Faser und Matrix bei thermischer Belastung (hohe Temperaturen über lange Zeiträume), die definierte Haftung zwischen Faser und Matrix, das definierte Verformungs- und Rißbildungsverhalten (bei mechanischer Belastung) und das definierte Rißausheilungsverhalten. Um diese komplexe Aufgabenstellung erfüllen zu können, ist es notwendig, unterschiedliche, voneinander getrennte und geometrisch definiert eingebrachte Fasern so in den Verbund unterzubringen, daß sie die obigen Aufgaben erfüllen können. Im wesentlichen handelt es sich dabei darum, diese Fasern bzw. Beschichtungsmaterialien in konzentrischen Schichten um die Fasern herum anzubringen. Die derart beschichtete Faser kann dann nach den beispielsweise aus DE 40 21 247 A1 beschriebenen Verfahren zur Herstellung von faserverstärkten Verbundwerkstoffen verwendet werden.

Beschichtungsvorrichtungen und Beschichtungsverfahren sind beschrieben unter anderem in DE 40 18 340 A1, US-PS 3 693 582 und FR-OS 2 281 997. Mit diesen bekannten Verfahren bzw. Vorrichtungen lassen sich jedoch stets eine Materialschicht auf die Faser oder, genauer gesagt, auf den Faserträger ("Seele" der Faser) aufbringen.

Der Erfindung liegt die Aufgabe zugrunde, eine Vorrichtung und ein Verfahren zum Beschichten von mindestens eine Einzelfaser aufweisendem Fasermedium zu schaffen, mit der sich gezielt auf eine Faser eine Vielzahl von aufeinanderfolgenden Schichten in Form von im wesentlichen konzentrischen Schichten aufbringen lassen.

Zur Lösung dieser Aufgabe wird mit der Erfindung eine Vorrichtung zum Beschichten von mindestens eine Einzelfaser aufweisendem Fasermedium vorgeschlagen, die versehen ist mit

- einer Trägervorrichtung zum Halten des zu beschichtenden mindestens eine Einzelfaser aufweisenden Fasermediums,
- einer Sputtervorrichtung mit mehreren Beschichtungszonen zum Aufbringen von Beschichtungsmaterialien, und
- einer Transportvorrichtung zum Transportieren des Fasermediums entlang eines Transportweges durch die Beschichtungszonen der Sputtervorrichtung zwecks sukzessiver Aufbringen mehrerer Lagen aus unterschiedlichem Beschichtungsmaterial auf das Fasermedium.

Bei der erfindungsgemäßen Vorrichtung durchläuft das zu beschichtende Fasermedium (eine oder mehrere Einzelfasern oder Endlos-Einzelfasern) mehrere Beschichtungszonen einer Sputtervorrichtung. In jeder Beschichtungszone wird Beschichtungsmaterial auf die Außenfläche des Fasermediums aufgebracht. Eine Transportvorrichtung transportiert das Fasermedium von Beschichtungszone zu Beschichtungszone sowie durch diese hindurch, womit sich mehrere Lagen von gegebenenfalls unterschiedlichem Beschichtungsmaterial auf dem Fasermedium niederschlagen.

Mit Hilfe der erfindungsgemäßen Vorrichtung lassen sich Fasermedien, d.h. Einzelfasern oder Endlos-Einzelfasern mit definiertem Schichtenaufbau herstellen. Die Reihenfolge der Schichten von innen nach außen und die Materialien, aus denen diese einzelnen Schichten bestehen, werden bestimmt durch die Reihenfolge, in der das Fasermedium durch die einzelnen Beschichtungszonen der Sputtervorrichtung hindurchtransportiert wird sowie durch die Zusammensetzung der Targets der einzelnen Beschichtungszonen. Die Dicke der einzelnen Schichten ist bestimmt durch die Verweildauer des Fasermediums in den einzelnen Beschichtungszonen (sowie von weiteren Parametern wie der Geometrie, der Leistung, dem Gasdruck etc.) oder kann dadurch beeinflußt werden, daß beispielsweise in zwei hintereinanderliegenden Beschichtungszonen das gleiche Beschichtungsmaterial aufgebracht wird.

Vorteilhafterweise transportiert die Transportvorrichtung das zu beschichtende Fasermedium vor Erreichen der ersten Beschichtungszone, in der Beschichtungsmaterial aufgebracht wird, durch eine Zone der Sputtervorrichtung hindurch, in der über einen Sputtervorgang insbesondere kleiner Leistung eine Reinigung des zu beschichtenden Fasermediums erfolgt.

Grundsätzlich läßt sich die erfindungsgemäße Vorrichtung sowohl zur schrittweisen Beschichtung von Einzelfasern endlicher Länge (beispielsweise bis zu 10 cm oder auch mehr) als auch zur kontinuierlichen

3

Beschichtung von Endlos-Einzelfasern einsetzen. Bei der schrittweisen, d.h. diskontinuierlichen Beschichtung werden die einzelnen Einzelfaserstücke von einer geeigneten Halterungsvorrichtung gehalten und von Beschichtungsstation zu Beschichtungsstation transportiert. Die einzelnen Fasern werden in der Halterungsvorrichtung parallel zueinander angeordnet gehalten. Zweckmäßigerweise ist die Halterungsvorrichtung ein rotationssymmetrischer Halter, der zwei im Abstand zueinander angeordnete Halteplatten aufweist, an denen die axialen Enden der Einzelfasern befestigt sind. Mehrere derartiger Halterungsvorrichtungen sind längs des Umfangs eines Drehtischs angeordnet, der schrittweise drehbar ist. Jede Halterungsvorrichtung selbst ist drehbar mit dem Drehtisch verbunden. Durch Rotation des Drehtischs werden die Halterungsvorrichtungen zwischen jeweils zwei eine Beschichtungszone definierende Targets einer Sputteranlage bewegt und dort angehalten. Unter Rotation der jeweils zwischen diesen beiden Targets angeordneten Halterungsvorrichtung erfolgt dann die Beschichtung sämtlicher von dieser Halterungsvorrichtung gehaltener Einzelfasern. Mehrere Paare von Targets sind in Umfangsrichtung des Drehtischs aufeinanderfolgend angeordnet. Diese Targets, von denen eins radial außerhalb und das andere radial innerhalb der Linie, längs der die Faserhalterungsvorrichtungen angeordnet sind, angeordnet ist, stehen fest, d.h. der Drehtisch läßt sich relativ zu den Targets drehen.

Die erfindungsgemäße Vorrichtung läßt sich aber auch zur kontinuierlichen Beschichtung von Endlosfasern zwecks Aufbringung mehrerer unterschiedlicher Schichten aus Beschichtungsmaterial einsetzen. Die einzelnen Beschichtungszonen der Sputteranlage können dabei linear hintereinanderliegen; zweckmäßig ist es aber, wie im bereits oben diskutierten Fall auch für die kontinuierliche Endlos-Einzelfaser-Beschichtung die Beschichtungsstationen im Kreis bzw. Ring anzuordnen. Hierbei wiederum ist es zweckmäßig, wenn das zu beschichtende Fasermedium in Schraubenform gehalten ist und sich dabei zwischen den einzelnen Beschichtungszonen hindurch erstreckt.

Um das zu beschichtende Fasermedium in Schraubenform zu halten, wird zweckmäßigerweise eine Trägervorrichtung verwendet, die mehrere entlang einer geschlossenen gedachten Linie angeordnete Trägerkörper aufweist, an denen das Fasermedium punkt- oder linienweise gehalten ist. Zwischen den einzelnen Trägerkörpern liegt das Fasermedium frei. An den Trägerkörpern ist ein Führungssystem zum Führen des Fasermediums ausgebildet. Die gesamte Trägervorrichtung steht fest, wobei durch Ausübung einer Zugkraft auf das Fasermedium dieses unter Beibehaltung seiner schraubenförmigen Anordnung an den Trägerkörpern vorbei bewegt wird. Das Fasermedium ist vorzugsweise auf einer Aufwickelvorrichtung, insbesondere in Form einer Aufwickelspule, aufgewickelt und wird von dieser abgezogen. Das an dem einen axialen Ende der schraubenförmigen Anordnung einlaufende Fasermedium wird anschließend der Schraubenlinie folgend transportiert, um am anderen axialen Ende tangential abgezogen und auf eine Aufwickelvorrichtung, insbesondere eine Aufwickelspule aufgewickelt zu werden. Die Trägerkörper, die die schraubenlinienförmige Anordnung des Fasermediums aufrechterhalten, bewegen sich nicht entlang der geschlossenen Linie, auf der sie zueinander benachbart in insbesondere gleichmäßigen Abständen angeordnet sind, sondern stehen insofern still. Allenfalls können die Trägerkörper um ihre eigene Längsachse (Achse in Erstreckung der axialen Ausbreitung der schraubenlinienförmigen Fasermediumanordnung) rotieren, um eine Gleit- bzw. Rutschreibung zwischen Fasermedium und Trägerkörper zu reduzieren bzw. zu eliminieren.

Die Paare von Targets der Sputteranlage sind zweckmäßigerweise zwischen benachbarten Trägerkörpern angeordnet. Dabei befindet sich pro Paar ein Target radial innerhalb und das andere Target radial außerhalb der gedachten Trägerkörper-Anordnungslinie, d.h. der Linie, entlang derer die Trägerkörper der Trägervorrichtung angeordnet sind. Bei den Targets handelt es sich um plattenförmige Elemente aus Beschichtungsmaterial, die parallel zueinander angeordnet sind und die sich in axialer Richtung über eine Vielzahl von Windungen der schraubenlinienförmigen Fasermediumanordnung erstrecken. Bei seinem Transport ist also das Fasermedium nach jeder Windung stets einem anderen Bereich des Target-Paares ausgesetzt. Vorzugsweise weist die Sputteranlage mehrere Paare von Targets auf, die in Umfangsrichtung der schraubenlinienförmigen Anordnung des Fasermediums und/oder in axialer Richtung der schraubenlinienförmigen Anordnung des Fasermediums versetzt angeordnet sind.

Um Streubeschichtungen und Einflüsse der von den Targets ausgehenden elektromagnetischen Felder benachbarter Paare von Targets zu unterbinden, wird zwischen die benachbarten Targets nebeneinanderliegender Target-Paare eine Abschirmung vorgesehen. Die Abschirmung zwischen in axialer Richtung der schraubenlinienförmigen Fasermedium-Anordnung benachbarter Targets erfolgt zweckmäßigerweise durch einen Abschirmring, wobei insbesondere an zwei derartige Ringe gedacht ist, die einerseits radial außerhalb und andererseits radial innerhalb der gedachten Trägerkörper-Anordnungslinie angeordnet sind. Zwischen beiden Ringen verbleibt ein Ringzwischenraum, durch den hindurch sich die schraubenlinienförmige Anordnung des Fasermediums erstreckt.

Wie bereits oben kurz angesprochen, "wandert" der einem Target-Paar ausgesetzte Bereich des Fasermediums während seines Transports längs der schraubenlinienförmigen Anordnung zwischen den Targets in zur Transportrichtung rechtwinkliger Richtung. Wenn man die Targets bereichsweise mit unterschiedlichen Beschichtungsmaterialien versieht, so ist damit eine Möglichkeit geschaffen, die Schichtenfolge und die Materialien der einzelnen Schichten, die sich auf dem Fasermedium abscheiden, zu beeinflussen. Zweckmäßigerweise sind die einzelnen Beschichtungsmaterialien innerhalb von Bereichen der Targets angeordnet, deren Form und Erstreckung in axialer Richtung des Fasermediums sowie in axialer Richtung der schraubenlinienförmigen Fasermedium-Anordnung zur Erzielung einer Beschichtung mit einer vorgegebenen Folge von einzelnen Beschichtungslagen und einer vorgegebenen stofflichen Zusammensetzung der einzelnen Beschichtungslagen entsprechend gewählt sind. Die Flächenanteile der unterschiedlichen Materialien relativ zueinander bestimmen die Zusammensetzung der einzelnen Schichten. Die Anordnung der einzelnen Beschichtungsmaterialbereiche in axialer Richtung der schraubenlinienförmigen Fasermedium-Anordnung beeinflussen die Schichtenfolge.

Ein maßgeschneideter Aufbau der Mikrostruktur eines Fasermediums wird mit der hier beschriebenen Erfindung vor allem durch die nachfolgend genannten Maßnahmen erreicht:

a) Der Transport des Fasermediums durch die einzelnen Beschichtungszonen der Sputtervorrichtung ermöglicht es, das Fasermedium mit mehreren Schichten definierter Dicke und Zusammensetzung durch Verwendung mehrerer nacheinander geschalteter Target-Paare zu belegen, wobei die Anordnung der Target-Paare der Sputtervorrichtung insbesondere dann platzsparend erfolgen kann, wenn das zu beschichtende Fasermedium bei seinem Transport eine schraubenlinienförmige Anordnung aufweist und beibehält.

b) Der Sputterprozeß erlaubt es, die Zusammensetzung der Schichten sowohl durch die Zusammensetzung des Targets (beispielsweise bestehend aus einer Legierung mit mehreren Elementen) als auch durch den Aufbau der Targets selbst, bestehend aus mehreren Einzelteilen, die mit ihrem Flächenanteil die Zusammensetzung der Schicht bestimmen, zu komponieren.

c) Indem die Targets in verschiedenen Höhen des durchlaufenden Fasermediums unterschiedlich durch Einzelteile aufgebaut werden, können auf das Fasermedium mit einem Target-Paar gleichzeitig mehrere Schichten unterschiedlicher Zusammensetzung aufgebracht werden. Die beiden Targets eines Paares sind dabei symmetrisch zueinander aufgebaut, sind also zueinander spiegelbildlich aufgebaut.

d) Chemisch gradierte Schichten lassen sich erzeugen, indem sich der Flächenanteil der einzelnen Bestandteile der aufzubringenden Schicht in axialer Richtung der schraubenlinienförmigen Fasermedium-Anordnung allmählich verändert wird (stetig und/oder differentiell). Chemisch gradierte Schichten können in den Fällen von Bedeutung sein, in denen zwischen aufeinanderfolgenden Schichten unterschiedliche thermische Ausdehnungskoeffizienten zu überbrücken sind.

e) Durch Variation der Sputterparameter (Gasdruck, Leistung usw.) können die Korngröße, der Fehlstelleneinbau, der Fremdgaseinschluß, die Haftung der Schicht an der jeweiligen Unterlage und die Restporengröße variiert werden. Dadurch lassen sich weitere Eigenschaften der aufgebrachten Schichten verändern und gradieren und auf diese Weise die Eigenschaften des derart beschichteten Fasermediums und des aus diesem hergestellten faserverstärkten Bauteil weiter beeinflussen.

f) In den Verbund können Schichten eingebaut werden, deren Aufgabe das Ausheilen von Rissen ist, die durch Überbelastungen entstanden sind. Zu diesem Zweck wird zwischen zwei Schichten mit hoher Schmelztemperatur eine Zwischenschicht mit einer Zusammensetzung vorgesehen, deren Bereich zwischen Liquidus- und Solidus-Linie des Phasendiagramms innerhalb der Anwendungstemperatur liegt. Risse, die in diesem Schichtbereich bei der genannten Temperatur auftreten, können bei geeigneter Schichtzusammensetzung ausgeheilt werden.

Die erfindungsgemäße Beschichtungsvorrichtung für Langfasermedium ist mit einer Trägervorrichtung zum Transportieren von (Lang-)Fasermedium versehen, bei der in der Sputtervorrichtung eine Trägervorrichtung zum Halten des Langfasermediums während des Transports angeordnet ist, wobei die Trägervorrichtung einzelne voneinander beabstandete Trägerkörper aufweist, an denen das Langfasermedium punkt- und/oder linienweise gehalten ist, wobei das Langfasermedium zwischen den Trägerkörpern freiliegt, und wobei die Trägervorrichtung ein Führungssystem zum Führen des Langfasermediums an den Trägerkörpern während des Transports des Langfasermediums aufweist.

Mit dieser Trägervorrichtung wird die Menge an dem Beschichtungsprozeß innerhalb der Beschichtungszone der Sputteranlage ausgesetztem Endlos-Langfasermedium stark vergrößert, d.h. der Durchlaufbereich, den das Langfasermedium innerhalb der Beschichtungszonen durchlaufen muß, stark vergrößert, um damit die Verweildauer des Langfasermediums in den Beschichtungszonen zu vergrößern. Dies wird erfindungsgemäß dadurch realisiert, daß das Langfasermedium während seines Transports im Durchlaufbereich von einer Trägervorrichtung schraubenlinienförmig gehalten ist. Dabei ist es prinzipiell möglich, daß die Menge an der Beschichtung unterzogenen Langfasermedium auch dadurch erhöht wird, daß das Langfasermedium mehrmals durch die eigentliche Beschichtungszone der Beschichtungskammer hindurchgeführt wird. Da eine Rundumbeschichtung des Langfasermediums erwünscht ist, ist beim Einsatz einer Trägervorrichtung zum Halten des Langfasermediums innerhalb der Beschichtungskammer darauf zu achten, daß es zu keinerlei dauerhaften, d.h. in jeder Phase des Transports des Langfasermediums vorliegenden Abschattungen durch die Kontakte bzw. Berührungen mit der Trägervorrichtung kommt. Erfindungsgemäß wird dieses Problem dadurch gelöst, daß die Trägervorrichtung einzelne entlang einer Kreis- oder geschlossenen Anordnungslinie positionierte Trägerkörper aufweist, die voneinander beabstandet sind und die das Langfasermedium längs seines Transportweges durch die Beschichtungszonen halten, wobei das Langfasermedium zwischen den einzelnen Trägerkörpern freiliegt. Durch die Trägerkörper wird also eine punkt- bzw. linienweise Anlage des Langfasermediums an der Trägervorrichtung geschaffen. Die Trägervorrichtung bzw. die Trägerkörper sind mit einem Führungssystem zum Führen des Langfasermediums während dessen Transport versehen.

Mit der Erfindung ist eine Transportvorrichtung für die insbesondere kontinuierliche Beschichtung im Durchlaufbetrieb von Einzelfasern, Fasersträngen und -bändern geschaffen, die es ermöglicht, das zu beschichtende Gut (Langfasermedium) durch eine Beschichtungsanlage derart hindurchzuführen und zu bewegen, daß eine im wesentlichen homogene Rundumbeschichtung der Fasern mit einer bezüglich Schichtenfolge und Materialzusammensetzung in weiten Grenzen frei wählbaren Beschichtung, eine optimale Ausnutzung des Verdampfungs-(Beschichtungs-) Materials und eine möglichst geringe thermische und mechanische Faserbelastung erzielt werden. Die Erfindung ist insbesondere zur (Kalt-)Beschichtung durch Sputtern o.dgl. geeignet.

Vorteilhafterweise ist das Langfasermedium mehrmals um die Anordnung von Trägerkörpern herum legbar und dabei an diesen gehalten sowie beim Transport geführt. Das Langfasermedium berührt dabei jeden Trägerkörper entlang seines Transportweges mehrere Male (entsprechend der Anzahl von Umläufen um die Anordnung von Trägerkörpern), wobei jeder Kontakt lediglich punkt- bzw. linienweise mit kleiner Linienlänge erfolgt. Zwischen jeweils zwei benachbarten Trägerkörpern ist dabei vorzugsweise eine Beschichtungszone (ein Paar Targets mit zugehörigen Kathoden) angeordnet: Pro Beschichtungszone sind dann der Anzahl von Umwicklungen des Langfasermediums um die Trägerkörperanordnung entsprechend viele Langfasermedium-Abschnitte dem Plasma ausgesetzt.

Zweckmäßigerweise sind die Trägerkörper gleichmäßig voneinander beabstandet. Zusätzlich ist es von Vorteil, wenn die Trägerkörper entlang eines Kreisumfangs angeordnet sind und in Form von Trägerwellen ausgebildet sind, die drehbar gelagert sind. Bei dieser Ausgestaltung der Erfindung weist das Führungssystem eine Vielzahl von Umfangsvertiefungen an den Trägerwellen auf. Sämtliche Trägerwellen sind parallel zueinander angeordnet und bilden zusammen einen Träger, um den herum das Langfasermedium mehr oder weniger stark gespannt geführt ist. Die Tiefe der einzelnen umlaufenden und pro Trägerwelle nebeneinander angeordneten Umfangsvertiefungen sollte derart gewählt werden, daß das Langfasermedium auch dann noch in den Umfangsvertiefungen geführt ist, wenn die Spannung auf das Langfasermedium nicht allzu groß ist. Dies hat den Vorteil, daß das Langfasermedium beim Umlenken um die einzelnen Trägerwellen keine allzu starke Krümmung erfährt, dennoch aber in den Umfangsvertiefungen verbleibt. Damit werden mechanische Faserbelastungen, nämlich Biegung und Reibung reduziert.

Wie oben bereits erwähnt, sind die Trägerwellen zweckmäßigerweise antreibbar. Der Drehsinn der Trägerwellen wird dabei derart gewählt, daß sich die Umfangsflächen der Trägerwellen in Transportrichtung des Langfasermediums bewegen, d.h. die Relativgeschwindigkeit zwischen Langfasermedium und den Umfangsflächen der Trägerwellen reduziert ist und im Idealfall verschwindet. Auf diese Weise kann die Gleitreibung des Langfasermediums an den Trägerwellen auf nahezu Null (Idealfall) reduziert werden, so daß lediglich noch "Rollreibung" verbleibt.

Wird das Langfasermedium mehrere Male um die Anordnung von Trägerwellen gelegt, so ist eine "Steigung" des Langfasermediums von Umlauf zu Umlauf erforderlich. Dies wird gemäß einer vorteilhaften Weiterbildung der Erfindung dadurch realisiert, daß die Umfangsvertiefungen benachbarter Trägerwellen axial versetzt zueinander sind. Für den Gesamtversatz der Umfangsvertiefungen der Trägerwellen gilt, daß dieser bei einer Einzelfaser als Langfasermedium gleich dem Abstand zweier benachbarter Umfangsvertiefungen ist. Werden Faserbänder beschichtet, die aus voneinander beabstandeten parallelen Endlos-Einzelfasern bestehen, so beträgt der Gesamtversatz einem Vielfachen einer Umfangsvertiefung; wird beispielsweise ein Faserband aus fünf Einzelfasern um die Trägervorrichtung herumgelegt, so beträgt der Versatz über den gesamten Kreisumfang betracht gleich dem Abstand von fünf Umfangsvertiefungen.

Um einen zumindest begrenzten Schutz gegen ein Ablösen des Langfasermediums von der Trägervorrichtung bei Faserbruch zu gewährleisten, ist gemäß einer vorteilhaften Weiterbildung der Erfindung vorgesehen, zwischen der Abwickelspule und der Trägervorrichtung und zwischen der Aufwickelspule und der Trägervorrichtung jeweils eine Langfasermedium-Festhaltevorrichtung vorzusehen. Zweckmäßigerweise besteht diese Langfasermedium-Festhaltevorrichtung jeweils aus einem ersten und einem zweiten Rollenpaar aus federnd mit ihren Laufflächen aneinanderliegenden Rollen mit parallelen Drehachsen, wobei das Langfasermedium zwischen den Laufflächen hindurchführbar ist. Die vier durch Bewegen des Langfasermediums drehbaren Rollen halten zwischen sich das Langfasermedium "eingeklemmt"; die Laufflächen (Umfangsflächen) der Rollen sind hierbei mit einem Teflon- oder einem Silikonüberzug versehen, der den Rollen eine "weiche" Berührungsfläche mit dem Langfasermedium verleiht. Tritt während der Beschichtung Faserbruch in demjenigen Bereich des Langfasermediums auf, in dem dieses um die Trägervorrichtung gelegt ist, so sorgen die Festhaltevorrichtungen dafür, daß das Langfasermedium auf den Spulen jeweils aufgewickelt und unter Zugspannung verbleibt. Tritt zwischen den Festhaltevorrichtung und einer der beiden Spulen ein Faserbruch auf, so bleibt die erforderlich Zugspannung des Langfasermediums im Bereich zwischen den beiden Festhaltevorrichtungen aufrechterhalten, so daß das Langfasermedium um die Trägervorrichtung gelegt verbleibt.

Die ersten Rollen und die zweiten Rollen sind in unterschiedlichen Ebenen angeordnet, die einen Winkel ungleich Null Grad miteinander bilden; vorzugsweise sind die ersten Rollen um 90° gegenüber den zweiten Rollen versetzt angeordnet. Die ersten Rollen einer jeden Langfasermedium-Festhaltevorrichtung sind der Trägervorrichtung zugewandt und garantieren eine exakte (Horizontal-)Führung des Langfasermediums, wenn ihre Drehachsen parallel zu den Trägerwellen angeordnet sind. Die zweiten Rollen, die der Aufwickel- bzw. der Abwickelspule zugeordnet sind, ermöglichen eine (Vertikal-)Führung des Langfasermediums beim Aufwickeln auf die Aufwickelspule bzw. beim Abwickeln von der Abwickelspule, wenn ihre Drehachsen parallel zur Auf- bzw. Abwickelspule verlaufen. Diese Horizontal- und Vertikalführungen reduzieren die Scherkraftbeanspruchungen, die auf das Langfasermedium wirken. Zweckmäßigerweise lassen sich die der Aufwickelspule zugewandten zweiten Rollen gemeinsam im wesentlichen in Erstreckung ihrer Drehachsen vor- und zurückbewegen, um das Langfasermedium zum geordneten, d.h. längenweisen Aufwickeln auf die Aufwickelspule zu führen.

Zu Beginn eines Beschichtungsprozesses ist es erforderlich, das Langfasermedium um die Trägervorrichtung herumzuführen und das Langfasermedium dabei in das Führungssystem einzubringen. Zweckmäßigerweise erfolgt dies automatisch, indem eine relativ zu der Trägervorrichtung bewegbare vorzugsweise automatisch arbeitende Mitnehmervorrichtung zum Aufbringen des Langfasermediums an die Trägervorrichtung und zum Einlegen des Langfasermediums in das Führungssystem vorgesehen ist, wobei das Langfasermedium an der Mitnehmervorrichtung befestigbar ist. Die Mitnehmervorrichtung ist dabei vorzugsweise von außen um die Anordnung von Trägerwellen herum bewegbar, wobei sie pro Umdrehung einen axialen Versatz erfährt, der gleich dem Gesamtversatz der Umfangsvertiefungen der Trägerwellen pro Umlauf ist. Mit anderen Worten ist das Steigungsmaß der Mitnehmervorrichtung pro Umdrehung gleich dem Umfangsvertiefungsversatz der Trägerwellen pro Umlauf um die Anordnung von Trägerwellen.

Die obigen Ausgestaltungen der Trägervorrichtung und des Führungssystems lassen sich bei einem Träger- und Führungsmechanismus für die Faserbeschichtung einsetzen. Die Erfindung umfaßt auch einen solchen nicht notwendigerweise eine Sputtervorrichtung und eine Transportvorrichtung umfassenden Träger- und Führungsmechanismus. Ferner sei erwähnt, daß dieser Träger- und Führungsmechanismus auch bei Anlagen einsetzbar ist, bei denen auf das Fasermaterial lediglich ein Beschichtungsmaterial aufgebracht wird.

Zusammenfassend kann gesagt werden, daß bei dem erfindungsgemäßen Verfahren das zu beschichtende Langfasermedium schraubenförmig angeordnet wird, wobei das unbeschichtete Langfasermedium aus einer Vorrats- bzw. Abnahme-/Abwickelvorrichtung (insbesondere von einer Vorratsspule) entnommen wird, durch eine Beschichtungsvorrichtung (insbesondere Sputter-Anlage) mit mehreren Beschichtungszonen zum schichtweisen Aufbringen von unterschiedlichen Materialien hindurch transportiert wird und danach einer Speicher- bzw. Aufnahme-/Aufwickelvorrichtung (insbesondere ebenfalls als Spule ausgebildet) für beschichtetes Langfasermedium zugeführt wird. Das Langfasermedium wird bei der Beschichtung in einer Schraubenlinienform mit mehreren Windungen gehalten, wobei sich das Langfasermedium bei seinem Transport entlang der Schraubenlinienform bewegt. Das sich entlang der Schraubenlinienform bewegende Langfasermedium wird durch die Beschichtungszonen hindurch transportiert, wobei sich die Beschichtungszonen über mehrere Windungen der Schraubenlinienform erstrecken. Hierbei ist es zweckmäßig, wenn das Langfasermedium in Abhängigkeit von der Lage der Windung oder in Abhängigkeit von der Lage einer Gruppe von insbesondere aufeinanderfolgenden Windungen der Schraubenlinienform unterschiedlichen Beschichtungszonen oder unterschiedlichen Bereichen der Beschichtungszonen ausgesetzt wird, in denen unterschiedliche Materialien auf das Langfasermedium aufgebracht werden.

Das nach der Erfindung beschichtete Fasermedium weist eine Faser aus Fasermaterial und eine auf die Faser aufgebrachte Matrixbeschichtung aus Matrixmaterial auf. Die Matrixbeschichtung ist in radialer Richtung betrachtet mehrlagig ausgebildet und umfaßt eine erste Schicht zum Abbau intrinsischer Spannungen zwischen Fasermaterial und Matrixmaterial und eine zweite Schicht aus sprödem Matrixmaterial. Die erste Schicht ist auf die Faser aufgebracht und besteht aus einem duktilen Matrixmaterial. Dabei ist das Material der zweiten Schicht, die aus insbesondere hochwarmfesten Matrixmaterial besteht, insbesondere wesentlich spröder als das duktile Matrixmaterial der ersten Schicht.

Zweckmäßigerweise umfaßt die Matrixbeschichtung eine dritte Schicht zum Ausfüllen von Zwischenräumen beim Verdichten benachbarter mit Matrixmaterial beschichteter Fasern, die auf die zweite Schicht der Matrixbeschichtung aufgebracht ist und insbesondere wesentlich duktiler als das spröde Matrixmaterial der zweiten Schicht ist.

Alternativ zum oben Gesagten kann die Matrixbeschichtung eine zweite Schicht aus sprödem und insbesondere hochwarmfestem Matrixmaterial und eine dritte Schicht zum Ausfüllen von Zwischenräumen beim Verdichten benachbarter mit Matrixmaterial beschichteter Fasern umfassen. Diese dritte Schicht besteht aus einem duktilen Matrixmaterial, welches insbesondere wesentlich duktiler als das spröde Matrixmaterial der zweiten Schicht ist.

Bei dieser Alternative ist es von Vorteil, wenn die Matrixbeschichtung eine erste Schicht zum Abbau intrinsischer Spannungen zwischen Fasermaterial und Matrixmaterial aufweist und die erste Schicht aus einem Material besteht, das insbesondere wesentlich duktiler als das spröde Matrixmaterial der zweiten Schicht ist.

Zweckmäßigerweise ist zwischen dem Fasermaterial und der Matrixbeschichtung eine weitere Schicht zur Steuerung der Haftung und Scherfestigkeit zwischen Fasermaterial und Matrixbeschichtung angeordnet.

Vorteilhafterweise befindet sich zwischen dem Fasermaterial und der Matrixbeschichtung eine zusätzliche Schicht als Diffusions- und Reaktionsbarriere.

Insbesondere ist die weitere Schicht auf dem Fasermaterial, die zusätzliche Schicht auf der weiteren Schicht und die Matrixbeschichtung auf der zusätzlichen Schicht angeordnet.

Mit der Erfindung ist es möglich, durch geeignete Wahl der Zusammensetzung, der Dicke und den sonstigen Eigenschaften der Matrixbeschichtungslagen sowie deren Reihenfolge Faserverbundwerkstoffe zu schaffen, die den mechanischen, thermischen und physikalischen Eigenschaften des Werkstoffs für den geplanten Anwendungsfall optimal angepaßt sind. Es wird mit der Erfindung gezeigt, daß es möglich ist, ganz gezielt die Zusammensetzung der Matrixbeschichtung und deren Schnittstelle zum Fasermaterial vorzugeben, um

- die Zug- und Druckfestigkeit,
- die Warmfestigkeit,
- die Ermüdungsfestigkeit,
- die Oxidationsbeständigkeit,
- die Dehnung/Schwindung,
- die Zeitstandsfestigkeit und
- das Rißausbreitungsverhalten

des mit dem Fasermaterial verstärkten Bauteils gezielt zu beeinflussen.

Nachfolgend wird anhand der Figuren ein Ausführungsbeispiel der Erfindung näher erläutert. Im einzelnen zeigen:

Fig. 1      eine Draufsicht auf einen Transportmechanismus für Langfasermedium zur kontinuierlichen Faserbeschichtung,

Fig. 2      eine Ansicht des Transportmechanismus entlang der Linie II von Fig. 1, in der die Umwicklung der Trägervorrichtung des Transportmechanismus mit Langfasermedium erkennbar ist,

Fig. 3      eine Ansicht des Transportmechanismus entlang der Linie II von Fig. 1, wobei die Situation in der Anfangsphase des automatischen Umwickelvorganges des Langfasermediums um die Trägervorrichtung mit Hilfe einer Mitnehmervorrichtung dargestellt ist,

Fig. 4      eine perspektivische Ansicht der von der Trägervorrichtung gemäß Fign. 1 bis 3 gehaltenen schraubenlinienförmigen Langfasermedium-Anordnung mit einer Vielzahl von einzelne Beschichtungszonen definierenden Target-Paaren,

Fign. 5 bis 7      Beispiele für die Beschichtungsmaterialbelegung der dem Langfasermedium zugewandten Seite eines Targets bei Betrachtung desselben gemäß Schnittansicht II-II der Fig. 4,

Fig. 8      eine Querschnittsansicht einer beschichteten Einzelfaser mit mehreren konzentrischen Schichten unterschiedlicher Materialzusammensetzung und

Fign. 9 und 10      Schliffbilder eines Faserverbundwerkstoffes nach einem Heißpreßvorgang oder einem heißisostatischen Preßvorgang.

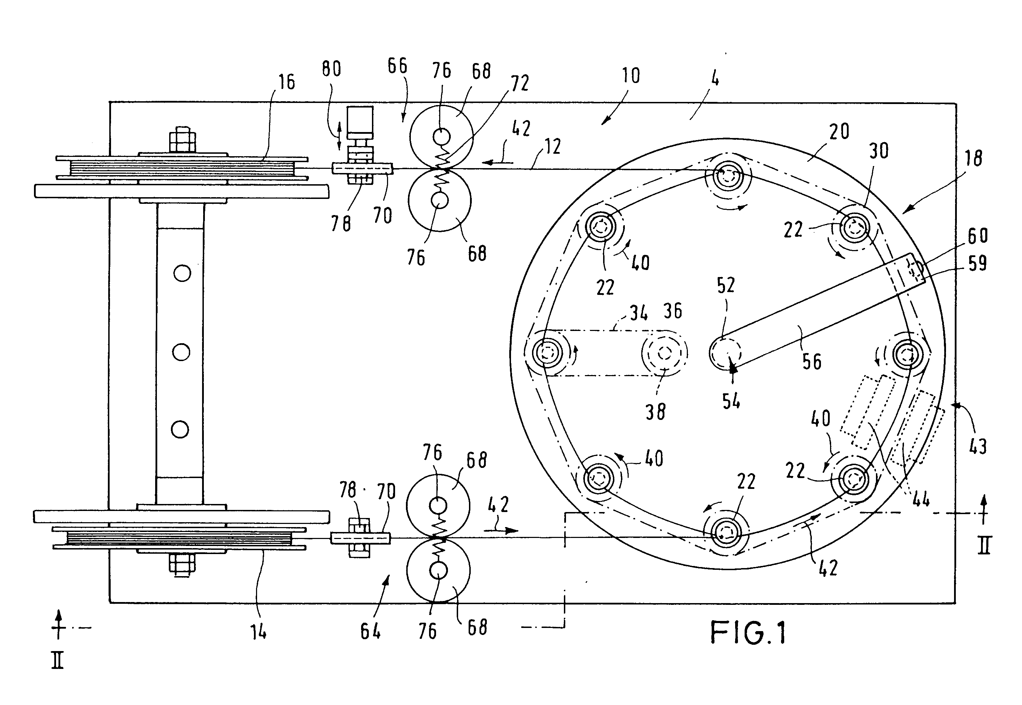

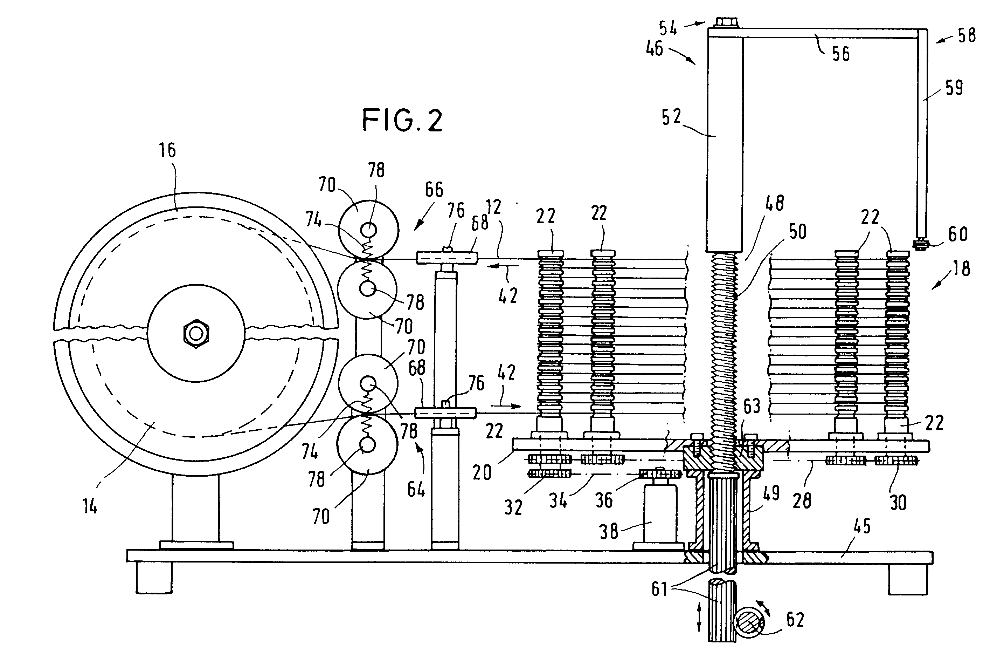

Fig. 1 zeigt in Draufsicht einen Transportmechanismus 10 zum Transportieren und Führen von Langfasermedium 12 in einer Beschichtungskammer zur kontinuierlichen Beschichtung des Langfasermediums 12. Wie man insbesondere anhand von Fig. 2, die eine Seitenansicht des Transportmechanismus 10 darstellt, erkennen kann, handelt es sich bei dem Langfasermedium 12 um eine Einzel-Langfaser. Der hier zu beschreibende und in den Figuren dargestellte Transportmechanismus 10 eignet sich beispielsweise zur Beschichtung von Silizium-Carbid-Fasern mit einer Titanbasislegierung als Beschichtungsmaterial.

Der Transportmechanismus 10 ist mit einer Abwickelspule 14 versehen, auf der zu beschichtendes Langfasermedium 12 (im vorliegenden Fall in Form einer Endlos-Einzelfaser) aufgewickelt ist. Das beschichtete Langfasermedium 12 wird von einer Aufwickelspule 16 aufgenommen. Zumindest die Aufwickelspule 16 ist antreibbar (in den Figuren ist der Antrieb aus Gründen der Übersichtlichkeit nicht dargestellt); es ist aber auch denkbar, daß sowohl die Aufwickel-als auch die Abwickelspule 16 bzw. 14 jeweils gegensinnig antreibbar sind, um dem Langfasermedium 12 in dem Bereich zwischen den beiden Spulen eine kontrollierte Zugspannung zu verleihen.

Im Transportweg zwischen der Abwickelspule 14 und der Aufwickelspule 16 ist eine Trägervorrichtung 18 angeordnet, um die herum das Langfasermedium 12 ausgehend von der Abwickelspule 14 mehrere Male gewickelt ist, um sich danach bis zur Aufwickelspule 16 zu erstrecken. Die Trägervorrichtung 18 weist eine feststehende runde Trägerplatte 20 auf, die eine Vielzahl von Trägerkörpern 22 in Form von drehend antreibbaren Trägerwellen (im Ausführungsbeispiel acht) trägt. Die Trägerwellen 22 sind jeweils drehbar an der Trägerplatte 20 gelagert. Sie sind längs einer Kreislinie und gleichmäßig voneinander beabstandet angeordnet. Jeder Trägerkörper 22 ist mit einer Vielzahl von Umfangsvertiefungen 24 versehen, die jeweils umlaufend geschlossen sind und in axialer Erstreckung der Trägerkörper 22 aufeinanderfolgen. Der axiale Versatz der Umfangsvertiefungen 24 zweier benachbarter Trägerkörper 22 beträgt 1/8 des Mittenabstandes zweier benachbarter Umfangsvertiefungen eines Trägerkörpers 22, so daß der Gesamtversatz über einen Umlauf der Anordnung von Trägerkörpern 22 betrachtet gleich einer Umfangsvertiefung 24 (Mittenabstand zwischen zwei benachbarten Umfangsvertiefungen) ist. Bei vollständig umwickelter Trägervorrichtung 18 erstreckt sich das Langfasermedium 12 mehrere Male um die Anordnung von Trägerwellen 22, wobei es jeweils in den Umfangsvertiefungen 24 punkt- bzw. linienweise geführt ist. Die Umfangsvertiefungen 24 bilden also das Führungssystem 26 der Trägervorrichtung 18.

Wie bereits oben angedeutet, sind die Trägerwellen 22 drehend antreibbar an der Trägerplatte 20 gelagert. Der Drehantrieb sämtlicher Trägerwellen 22 erfolgt über einen Riementrieb 28, der um Rollen 30 geführt ist, die starr mit den Trägerwellen 22 verbunden sind. Jede Trägerwelle 22 ist mit einer derartigen Rolle 30 verbunden, wobei eine der Trägerwellen 22 eine zweite Rolle 32 aufweist, die über einen weiteren Riementrieb 34 mit der Antriebsrolle 36 eines Motors 38 gekoppelt ist. Dieser Antriebsmechanismus für die Trägerwellen 22 erlaubt den unabhängigen Antrieb der Trägerwellen 22 von der Rotation der Abwickel- und Aufwickelspulen 14,16. Der hier beschriebene Antriebsmechanismus für die Trägerwellen 22 ermöglicht es, sämtliche Trägerwellen 22 gleichsinnig und mit gleicher Geschwindigkeit rotieren zu lassen. Die Rotationsrichtung der Trägerwellen 22 (s. die Pfeile 40 in Fig. 1) ist dabei derart gewählt, daß sich die Trägerwellen 22 gleichsinnig mit der Transportrichtung des Langfasermediums 12 (s. Pfeil 42 in Fig. 1) um die Anordnung von Trägerwellen 22 drehen.

Im Betrieb des Transportmechanismus 10 wird unbeschichtetes Langfasermedium 12 von der Abwickelspule 14 abgewickelt. Das von der Abwickelspule 14 kommende Langfasermedium 12 umläuft mehrere Male die Anordnung von Trägerwellen 22, wobei es außen in den Umfangsvertiefungen 24 der Trägerwellen 22 geführt und gehalten ist. Die Trägerwellen 22 drehen sich gleichsinnig mit der Umlaufrichtung des Langfasermediums 12 um die Trägervorrichtung 18, so daß die Reibung zwischen den Umfangsvertiefungen 24 und dem Langfasermedium 12 reduziert ist. Von der Trägervorrichtung 18 erstreckt sich das Langfasermedium 12 dann weiter bis zur Aufwickelspule 16, die beschichtetes Langfasermedium 12 trägt. Zwischen zwei benachbarten Trägerwellen 22 befindet sich die Erzeugungsvorrichtung 43 für das eigentliche Beschichtungsplasma (in den Figuren durch gestrichelte Linien angedeutet), die zwei feststehende Target/ Kathoden-Anordnungen 44 aufweist, welche einander gegenüberliegend angeordnet sind. Das Beschichtungsplasma bildet sich zwischen diesen beiden Target/Kathoden-Anordnungen 44 aus. Das Langfasermedium 12 verläuft zwischen den beiden Target/Kathoden-Anordnungen 44, wobei sich bei Bewegung des Langfasermediums 12 gleichzeitig mehrere Abschnitte desselben (entsprechend der Anzahl an Langfasermedium-Wicklungen um die Anordnung von Trägerwellen 22) durch die Erzeugungsvorrichtung 43 hindurchbewegen.

Der gesamte Transportmechanismus 10 ist auf einer Grundplatte 44 angeordnet, die als solche in eine Beschichtungskammer eingebracht werden kann. Es ist aber auch denkbar, daß lediglich die Trägervorrichtung 18 sich in der Beschichtungskammer befindet, welche dann zwei Öffnungen zum Einführen von unbeschichtetem Langfasermedium 12 in die Beschichtungskammer und Herausführen von beschichtetem Langfasermedium 12 aus der Beschichtungskammer aufweist.

Zur Erleichterung des Aufwickelns des Langfasermediums auf die Trägervorrichtung 18 ist der Transportmechanismus 10 mit einer Mitnehmervorrichtung 46 für Langfasermedium 12 versehen. Die Mitnehmervorrichtung 46 weist eine drehbare Spindel 48 mit einem Außengewinde 50 auf, die im Gewindeeingriff mit einem fest mit der Trägerplatte verbundenen Teil (z.B. Standfuß 49) steht. Die Spindel 48 ist im Mittelpunkt derjenigen (gedachten) Kreislinie angeordnet, auf der sich die einzelnen Trägerwellen 22 befinden. Mit dem oberen Ende der Spindel 48 ist ein Hohlstab 52 verbunden, der in axialer Verlängerung der Spindel 48 verläuft und dessen der Trägerplatte 20 abgewandtes axiales Ende 54 den radialen Schenkel 56 eines Winkel-Arms 58 trägt. Der Winkel-Arm 58 weist neben dem radialen Schenkel 56 auch einen axialen Schenkel 59 auf, der sich außerhalb der Anordnung von Trägerwellen 22 befindet. Das dem radialen Schenkel 56 abgewandte freie Ende des axialen Schenkels 59 weist eine Befestigungsvorrichtung 60 auf, an der das Ende des Langfasermediums 12 befestigbar ist. Der sich unterhalb der Trägerplatte 22 (durch den Fuß 49) hindurch erstreckende untere axiale Abschnitt 61 der Spindel 48 weist eine in Umfangsrichtung verlaufende Zahnung auf, deren "Täler" und "Berge" in axialer Richtung der Spindel 48 verlaufen. Mit dieser Zahnung kämmt eine Antriebsschnecke 62. Durch drehenden Antrieb der Schnecke 62 wird die Spindel 48 in Rotation versetzt, wodurch sich diese infolge ihres Gewindeeingriffs mit einem mit der Trägerplatte 20 fest verbundenen Gewindeteil 63 axial verschiebt. Die mit der Antriebsschnecke 62 kämmende Zahnung der Spindel 48 weist eine ausreichende axiale Erstreckung auf, so daß diese Kämmung auch in den beiden axialen Extremstellungen der Spindel 48 (vollständig eingezogen bzw. ausgefahren) besteht.

Zu Beginn eines Aufwickelvorganges befindet sich der Hohlstab 52 nahezu in Anlage mit der Trägerplatte 20, wobei die Befestigungsvorrichtung 60 am Winkel-Arm 58 in Höhe der untersten Umfangsvertiefungen 24 der Trägerwellen 22 angeordnet ist. Durch Rotation des Winkel-Arms 58 bei an der Befestigungsvorrichtung 60 befestigtem Langfasermedium wird dieses Umdrehung für Umdrehung um die Trägervorrichtung 18 gewickelt. Diese Rotation des Winkel-Arms 58 kommt bei Drehung der Antriebsschnecke 62 zustande. Die Rotationsgeschwindigkeiten der Spindel 48 bzw. des Winkelarms 58 und der Trägerwellen 22 sind beim Aufwickelvorgang derart aufeinander abgestimmt, daß die Relativbewegung zwischen den Umfangsflächen der Trägerwellen 22 und dem Langfasermedium in den Kontaktpunkten bzw. -linien beider gleich Null ist. Das Steigungsmaß des Außengewindes 50 der Spindel 48 ist dabei derart gewählt, daß der axiale Versatz des Winkel-Arms 58 pro Umdrehung gleich dem Mittenabstand zweier benachbarter Umfangsvertiefungen 24 ist. Nach Beendigung des Aufwickelvorganges wird das an der Befestigungsvorrichtung 60 gehaltene Ende des Langfasermediums 12 abgenommen und an der Aufwickelspule 16 befestigt. Die Mitnehmervorrichtung 46 weist dann die Anordnung gemäß Fig. 2 auf. Für die eigentliche Beschichtung des Langfasermediums 12 kann der Winkelarm 58 der Mitnehmervorrichtung 46 entfernt werden.

Die Transportgeschwindigkeit des Langfasermediums 12 ist bei dem hier beschriebenen und in den Figuren dargestellten Transportmechanismus 10 variabel und wird dem Beschichtungsprozeß angepaßt. Die gesamte Anlage kann für Hochvakuum ausgeführt werden. Der Transportmechanismus 10 kann in praktisch jeder Lage betrieben werden, d.h. mit horizontal angeordneten Spulen 14,16 bei vertikal ausgerichteten Trägerwellen 22 oder mit vertikal angeordneten Spulen 14,16 bei ebenfalls vertikal ausgerichteten Trägerwellen 22. Es ist aber auch möglich, daß die Trägerwellen 22 jeweils horizontal ausgerichtet sind. Das gesamte System kann sowohl auf dem Kammerboden einer Beschichtungsanlage als auch um 180° gedreht an dem Kammerdeckel montiert werden. Damit ist der hier beschriebene Transportmechanismus praktisch für alle Bauausführungen von Beschichtungsanlagen geeignet. Bei Vakuumkammern mit großen Durchmessern ist auch eine Anordnung der Spulen innerhalb der Anordnung von Trägerwellen 22 möglich.

Zwischen der Trägervorrichtung 18 und der Abwickelspule 14 und zwischen der Trägervorrichtung 18 und der Aufwickelspule 16 ist jeweils eine Langfasermedium-Festhaltevorrichtung 64,66 angeordnet. Aufgabe dieser Festhaltevorrichtung 64,66 ist einerseits die Führung des Langfasermediums zwischen den Spulen 14,16 und der Trägervorrichtung 18 und andererseits das Festhalten des Langfasermediums im Falle eines Faserbruchs. Jede Festhaltevorrichtung 64,66 weist eine Rollenpaaranordnung aus zwei horizontal angeordneten ersten Rollen 68 mit parallelen Drehachsen und zwei vertikal angeordneten zweiten Rollen 70 mit ebenfalls parallelen Drehachsen auf. Sowohl die beiden ersten Rollen 68 als auch die beiden zweiten Rollen 70 liegen federnd aneinander an, was in den Figuren durch die Federn 72,74 zwischen den Drehachsen 76,78 wiedergegeben ist. Zwischen den Lauf-(Umfangs-)Flächen der ersten und zweiten Rollen 68,70 erstreckt sich das Langfasermedium 12, wobei die Laufflächen der sich bei Bewegung des Langfasermediums 12 mitdrehenden Rollen 68, 70 an dem Langfasermedium 12 anliegen. Tritt Faserbruch auf, z.B. zwischen der Festhaltevorrichtung 64,66 und den Spulen 14,16 oder der Trägervorrichtung 18, so verbleibt das Langfasermedium 12 um die Trägervorrichtung 18 gewickelt bzw. auf den Spulen 14,16 aufgewickelt, womit ein Schutz gegen ungewolltes Abwickeln von Langfasermedium 12 im Fall von dessen Bruch gegeben ist.

Die der Trägervorrichtung 18 zugewandten ersten Rollen 68 der zwischen der Trägervorrichtung 18 und der Abwickelspule 14 angeordneten Festhaltevorrichtung 64 sind in Höhe der untersten (obersten) Umfangsvertiefung 24 der in Transportrichtung des Langfasermediums 12 nächsten Trägerwelle 22 angeordnet, an der das Langfasermedium 12 anliegt (s. Fig. 1). Ebenso sind die ersten Rollen 68 der anderen Festhaltevorrichtung 66 in Höhe der Umfangsvertiefung 24 der in Transportrichtung des Langfasermediums 12 letzten vor der Festhaltevorrichtung 66 gelegenen Trägerwelle 22 angeordnet. Die ersten Rollen 68 der beiden Festhaltevorrichtungen 64,66 dienen der exakten Horizontal-Führung des Langfasermediums 12 zu der Trägervorrichtung 18 hin und von dieser weg, indem eine Bewegung des Langfasermediums 12 in radialer Richtung der in Transportrichtung 42 ersten Trägerwelle 22 unterbunden wird. Demgegenüber übernehmen die zweiten (Vertikal-) Rollen 70, die um 90° verdreht gegenüber den ersten Rollen 68 angeordnet sind, die Führung des Langfasermediums 12 beim Abwickeln von der Abwickelspule 14 bzw. beim Aufwickeln auf die Aufwickelspule 16, wobei die zweiten Rollen 70 auf der Abwickelspulen-Seite auch der genauen Zuführung des Langfasermediums 12 zu den ersten Rollen 68 hin dienen. Die der Aufwickelspule 16 zugeordneten zweiten Rollen 70 der Festhaltevorrichtung 66 sind seitlich hin- und herbewegbar (was in Fig. 1 durch den Doppelpfeil 80 angedeutet sein soll), um einen scherkraftfreien bzw. -reduzierten Aufwickelvorgang des beschichteten Langfasermediums 12 zu ermöglichen.

Mit der Vorrichtung gemäß Fign. 1 bis 3 läßt sich Langfasermedium (im vorliegenden Fall eine Endlos-Einzelfaser) kontinuierlich im Durchlaufbetrieb mit einer (einzigen) Außenschicht versehen; denn die Einzelfaser ist während ihres Transports längs der Schraubenlinie abschnittsweise dem einen Target/Kathoden-Paar 43/44 ausgesetzt. Die Targets 44 erstrecken sich über die gesamte axiale Erstreckung der schraubenlinienförmigen Anordnung des Langfasermediums. Die Dicke der Außenschicht hängt neben der Sputterrate auch davon ab, wie oft die Endlos-Einzelfaser das Target/Kathoden-Paar 43/44, das zwischen sich die (einzige) Beschichtungszone definiert, durchläuft (Gesamtverweildauer).

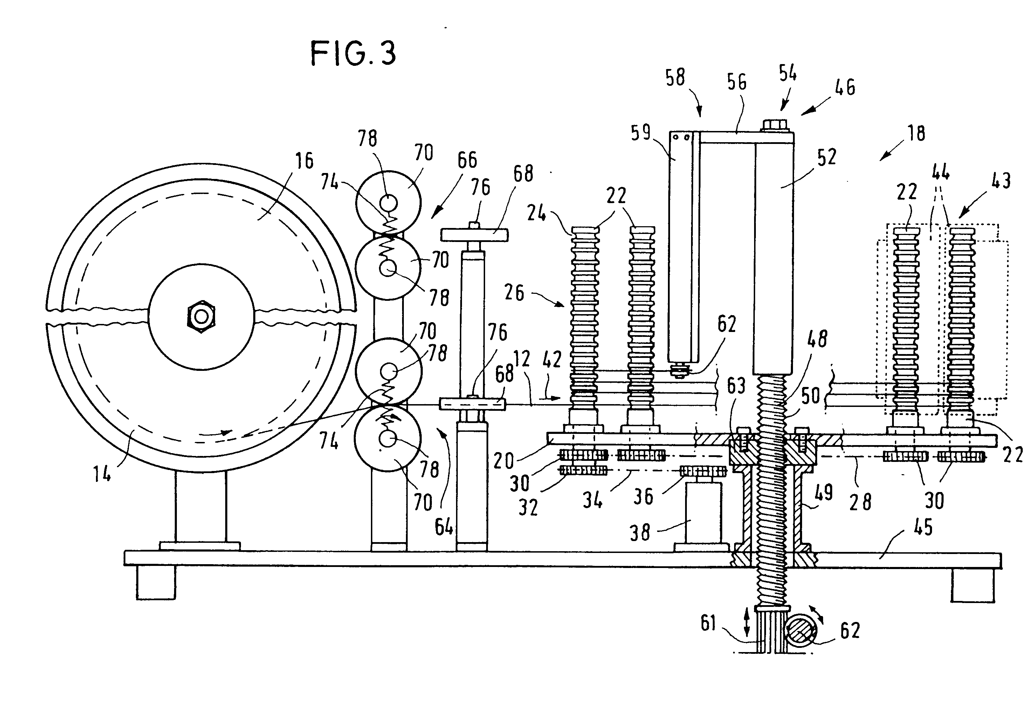

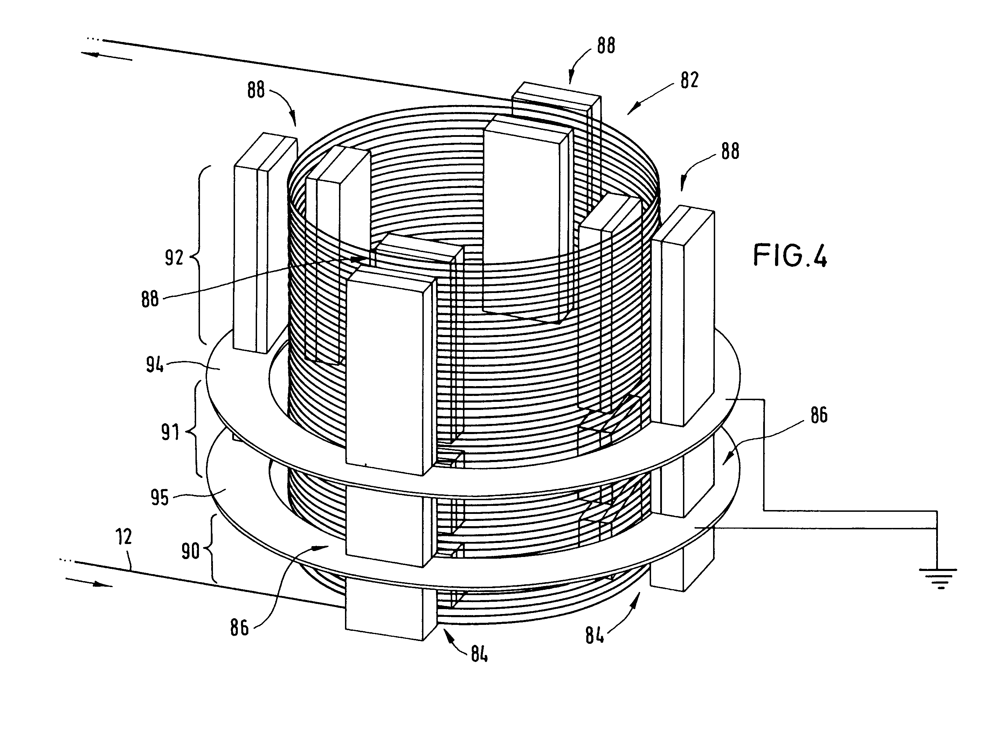

Fig. 4 zeigt die schraubenlinienförmige Anordnung 82 der von der (in Fig. 4 nicht dargestellten) Trägervorrichtung gehaltenen Endlos-Einzelfaser 12 und eine Vielzahl von Target/Kathoden-paaren 84,86,88, zwischen denen sich die Endlos-Einzelfaser 12 bei ihrem Transport längs der Schraubenlinie hindurch erstreckt. Während in den Fign. 1 und 3 lediglich ein derartiges Target/Kathoden-Paar angedeutet ist, zeigt Fig. 4 den Fall, daß die Endlos-Einzelfaser mehreren Beschichtungszonen ausgesetzt ist, innerhalb derer sukzessive unterschiedliche Materialzusammensetzungen auf die Außenfläche der Einzelfaser aufgebracht werden.

Von der (in Fig. 4 nicht dargestellten) Abwickelspule kommend läuft das Langfasermedium 12 am unteren Ende der Fig. 4 tangential in die schraubenlinienförmige Anordnung 82 ein, verläuft dann der Schraubenlinie entsprechend in Umfangsrichtung bei geringfügiger axialer Steigung bis zum oberen Ende der Schraubenlinienform 82, um dort tangential von dieser zu der (in Fig. 4 ebenfalls nicht dargestellten) Aufwickelspule geführt zu werden. Die in Fig. 4 durch die Target/Kathoden-Paare 84,86,88 repräsentierte Sputtervorrichtung ist - in axialer Richtung der Schraubenlinienanordnung 82 - in drei Bereiche 90,91,92 und - in Umfangsrichtung der Schraubenlinienanordnung 82 - pro Bereich mit vier Target/Kathoden-Paaren 84 (für Bereich 90), 86 (für Bereich 91) und 88 (für Bereich 92) unterteilt. Die einzelnen Bereiche 90 bis 92 der Sputtervorrichtung sind durch metallische Ringblenden-Paare 94, 95, unterteilt. Jedes Blendenring-Paar weist einen außerhalb der Schraubenlinienanordnung 82 befindlichen Blendenring und einen innerhalb der Schraubenlinienanordnung 82 angeordneten Blendenring auf, der in Fig. 4 der besseren Übersichtlichkeit wegen nicht dargestellt ist. Die beiden konzentrischen Blendenringe jedes Blendenring-Paars 94,95 weisen einen radialen Abstand voneinander auf, durch den hindurch sich das Langfasermedium 12 der Schraubenlinienanordnung 82 erstreckt. Die Blendenring-Paare 94,95 schirmen die einander zugewandten Enden der in axialer Richtung der Schraubenlinienanordnung 82 nebeneinanderliegenden Target/Kathoden-Paare 84,86,88 gegeneinander ab, indem sie zwischen jeweils benachbarten Targets/Kathoden nebeneinanderliegender Paare 84,86,88 verlaufen. Das in die Schraubenlinienanordnung 82 einlaufende Langfasermedium 12 durchläuft zunächst den Bereich 90 der Sputtervorrichtung, in dem es durch die von den vier Target/Kathoden-Paaren 84 gebildeten Zonen hindurchtransportiert wird. In diesen Zonen wird die noch unbeschichtete Endlos-Einzelfaser einem Reinigungsvorgang unterzogen, der am besten in Form eines RF-Sputtervorgangs kleiner Leistung erfolgt. Andere Reinigungsverfahren, wie beispielsweise Ionenbeschuß aus Ionenquellen, Elektronenbeschuß aus Elektronenquellen u.dgl. können ebenfalls verwendet werden.

Nachdem das Langfasermedium 12 über mehrere Windungen der Schraubenlinienanordnung 82 mehrere Male zwischen jedem Target/Kathoden-Paar 84 hindurchtransportiert worden ist, gelangt es in den durch die Ringblenden-Paare 94,95 definierten Bereich 91, in dem es den Target/Kathoden-Paaren 86 ausgesetzt ist. In diesem zweiten Bereich wird das Langfasermedium einem oder mehreren RF- oder DC-Sputtervorgängen ausgesetzt, um auf die gereinigte Faser Schutzschichten aufzubringen, deren Aufgabe in einer Unterbindung der Wechselwirkung der eigentlichen Faser mit der Beschichtungsmatrix durch Diffusion und Reaktion besteht. Werden in dem Bereich 91 über die Target/Kathoden-Paare 86 gemäß Fig. 4 hinaus weitere Target/Kathoden-Paare vorgesehen, die axial versetzt zu den Paaren 86 angeordnet sind, so können in diesem zweiten Bereich weitere Schichten mit beispielsweise den Aufgaben eingebracht werden, um eine definierte Haftung und Scherfestigkeit zwischen der eigentlichen Faser und der Matrix herzustellen.

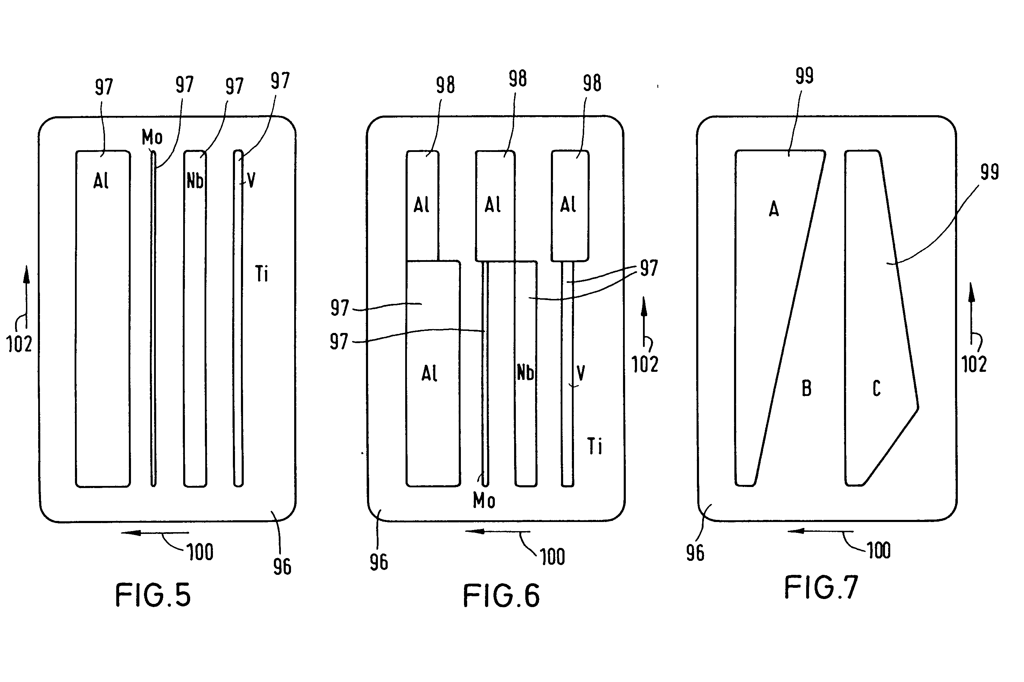

Schließlich gelangt die Endlos-Einzelfaser 12 in den dritten Bereich 92 der Sputtervorrichtung, in dem sie den Target/Kathoden-Paaren 88 ausgesetzt ist, die für die Beschichtung mit Matrixmaterial sorgen. Der Sputtervorgang kann als DC- oder RF-Matrixbeschichtungsvorgang ausgebildet sein. Die Matrix kann aus einer einzelnen Substanz (Legierung, Keramik) bestehen, oder sie kann zur Steuerung des Verhaltens der Mikrostruktur der Matrix aus mehreren nacheinander aufzubringenden Schichten aufgebaut sein. Dazu können mehrere Target/ Kathoden-Paare in axialer Erstreckung der Schraubenlinienanordnung 82 vorgesehen sein, oder aber es können geeignet aufgebaute Targets verwendet werden, wie sie beispielsweise in den Fign. 5 bis 8 dargestellt sind.

Die auf die zuvor genannte Weise mit mehreren konzentrischen Schichten versehene Endlos-Einzelfaser wird in hier nicht näher zu beschreibender Weise zur Herstellung eines Faserverbundwerkstoffes, d.h. eines faserverstärkten Bauteils, weiterverarbeitet. Eine Möglichkeit der Herstellung eines faserverstärkten Bauteils ist in DE-OS 40 21 547 beschrieben.

Hauptaspekt des Beschichtungsverfahrens bzw. der Beschichtungsvorrichtung gemäß Fig. 4 ist es, das Langfasermedium 12 kontinuierlich im Durchlaufbetrieb bei platzsparender Anordnung der Sputtervorrichtung einer Vielzahl von unterschiedlichen Beschichtungszonen zuzuführen, in denen unterschiedliche Materialien aufgebracht werden, wobei die Aufeinanderfolge der Schichten, deren einzelne Schichtdicken und deren Materialzusammensetzungen durch die Wahl der sukzessive hintereinander zu passierenden Beschichtungszonen, durch die Wahl der jeweiligen Verweildauer des Langfasermediums in den einzelnen Beschichtungszonen und durch die Beeinflussung der Materialien der Targets steuerbar sind. Werden, wie gemäß Fig. 4 vorgesehen, in axialer Erstreckung der Schraubenlinienanordnung 82 unterschiedliche Target/Kathoden-Paare zur Erzielung unterschiedlicher Beschichtungen vorgesehen, so sollten diese, wie ebenfalls in Fig. 4 dargestellt, durch geeignete Abschirmungsvorrichtungen (in Fig. 4 sind dies die Blendenring-Paare 94,95) gegeneinander abgeschirmt werden, um Streubeschichtungen und Beeinflussung benachbarter Target/Kathoden-Paare durch elektromagnetische Streufelder weitestgehend zu unterdrücken.

Beispiele für den Aufbau eines Targets 96 sind in den Fign. 5 bis 7 dargestellt. Dabei ist zu berücksichtigen, daß diese Figuren diejenigen Flächen der Targets 96 zeigen, die der zu beschichtenden Faser ausgesetzt sind. Ferner ist zu beachten, daß ein jeweils zu beschichtender Abschnitt der Faser, der gerade an dem Target 96 vorbeigeführt wird, nicht dem gesamten Target 96 ausgesetzt ist, sondern jeweils nur einem im wesentlichen durch den Durchmesser der Faser (inkl. eventuell bereits aufgebrachter Beschichtung) entsprechenden streifenförmigen Bereich. Die Endlos-Einzelfaser bewegt sich nämlich bei ihrem Transport in Umfangsrichtung (siehe die Pfeile 100 in den Fign. 5 bis 7) in Richtung des streifenförmigen Bereichs und "wandert" mit zunehmendem Transport in Richtung der Pfeile 102 der Fign. 5 bis 7 quer zur Erstreckung der streifenförmigen Bereiche, um auf diese Weise den gesamten Flächenbereich der Targets zu überstreichen.

In Fig. 5 ist ein Beispiel eines Targets 96 dargestellt, bei dem die Endlos-Einzelfaser unabhängig von ihrer Lage relativ zum Target mit demselben Beschichtungsmaterial belegt wird. Im Beispiel der Fig. 5 wird die Faser mit einer Titan Super α 2-Legierung beschichtet. Die einzelnen Bereiche 97, die in dem Titan-Target 96 vorgesehen sind, bestehen aus den Elementen dieser Legierung. Dabei sind die Flächenanteile dieser Bereiche 97 entsprechend den Anteilen der Elemente an der Gesamtlegierung gewählt.

Fig. 6 zeigt ein Beispiel für ein Titan-Target 96, bei dem mit einem Target zwei Materialschichten sukzessive hintereinander auf die Faser aufgebracht werden. In einem ersten Bereich des Targets (untere Hälfte bis untere 2/3 des Targets gemäß Fig. 6) wird auf die Faser eine Super α 2-Legierung aufgebracht, während im oberen Teil des Targets 96 eine Titan-Aluminium-Legierung aufgebracht wird (s. Aluminium-Bereiche 98). In Abhängigkeit von der Lage der zu beschichtenden Faser relativ zum Target 96 können somit also unterschiedliche Materialien aufgebracht werden. Fig. 6 ist also ein Beispiel für ein Target, mit dem bei einer Sputtervorrichtung eine Beschichtungszone zwischen zwei Targets in Beschichtungsunterzonen unterteilt werden kann, in denen unterschiedliche Materialien bzw. Materialzusammensetzungen auf das zu beschichtende Teil aufgebracht werden können.

Fig. 7 zeigt ein Beispiel für die Ausbildung eines Targets 96, bei dem sich die Materialzusammensetzung der Beschichtung graduell verändert. Während gemäß der Fign. 5 und 6 die einzelnen Flächenbereiche 97,98, in denen das Target mit unterschiedlichen Materialien belegt ist, in Richtung der Pfeile 102 pro Bereich breitenmäßig unverändert sind, verändert sich bei dem Ausführungsbeispiel gemäß Fig. 7 die Breite der Bereiche 99, denen die zu beschichtende Faser bei ihrer Bewegung in Richtung des Pfeils 102 ausgesetzt ist, allmählich. Das Target 96 selbst besteht aus dem in Fig. 7 mit B bezeichneten Material. In das Target 96 sind beliebig geformte und angeordnete Flächenbereiche 99 mit den mit A und C bezeichneten Materialien eingelassen. Durch entsprechende Wahl der Flächen und der Anordnung der Bereiche 99 läßt sich die Zusammensetzung der Beschichtung einer Faser in Abhängigkeit des Radius allmählich beeinflussen. Dies kann von Vorteil sein, wenn es um den Ausgleich unterschiedlicher thermischer Ausdehnungskoeffizienten geht.

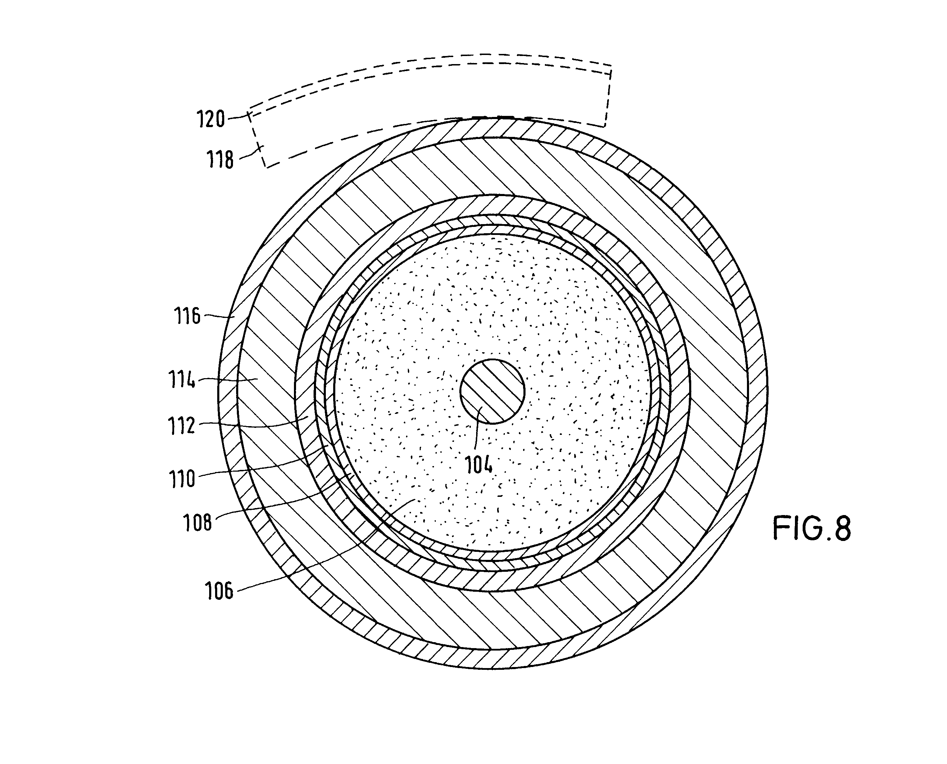

Anhand von Fig. 8 soll nachfolgend ein Beispiel für die Schichtenfolge einer SiC-Faser erläutert werden. Die beschichtete Faser gemäß Fig. 8 weist einen Kohlenstoff-Faserkern 104 auf, der als Träger für die Beschichtung mit SiC 106 dient. Der Faserkern 104 und die Fasermaterialbeschichtung 106 bilden die eigentliche SiC-Faser, die als unbeschichtete und zu reinigende Faser auf der Abwickelspule aufgewickelt ist und der schraubenlinienförmigen Anordnung 82 der Fig. 4 zugeführt wird.

Auf die SiC-Schicht 106, die die hohe Festigkeit der beschichteten Faser liefert, wird zur Beeinflussung der Haftung und Scherfestigkeit zwischen der eigentlichen Faser und dem diese umgebenden Beschichtungsmaterialmantel eine Zwischenschicht 108 aufgebracht. Diese Schicht 108 besteht aus z.B. Kohlenstoff. Auf diese Zwischenschicht 108 wird eine Diffusions- und Reaktionsbarriere in Form der Schicht 110 aufgetragen. Bei dieser Schicht 110 handelt es sich beispielsweise um eine $TiB_2$-Materialschicht. Auf die Schicht 110 ist eine (duktile) Verbundmatrixschicht 112 aus einer Ti-Legierung aufgetragen, die die intrinsischen Spannungen zwischen der Faser und der Matrix abbauen soll, weshalb sie vorzugsweise duktil ist. Diese Schicht 112 verhindert letztendlich eine Rißbildung, da sie die intrinsischen Spannungen, die infolge der unterschiedlichen E-Module von Fasermaterial und Matrixmaterial bei äußeren Belastungen des faserverstärkten Bauteils entstehen, abbaut.

Die duktile Verbundmatrixschicht 112 ist umgeben von einer hochwarmfesten Verbundmatrixschicht 114, bei der es sich beispielsweise um eine TiAl-Legierung handelt. Das Material dieser Schicht 114 stellt bei fertigem Bauteil das Matrixmaterial des faserverstärkten Bauteils dar, das in erster Linie dazu dient, Berührungen benachbarter Fasern zu verhindern und die Fasern in definiertem Abstand zu halten. Eine weitere Aufgabe des Matrixmaterials besteht im Korrosionsschutz. Als letzte Schicht ist um die hochwarmfeste Verbundmatrixschicht 114 herum eine (duktile) Außenschicht 116 als Verdichtungshilfe angeordnet. Diese Schicht 116 besteht beispielsweise aus einer Titan-Legierung. Dieser Schicht 116 kommt die Aufgabe zu, die Hohlräume zwischen den einzelnen beschichteten Fasern beim Heißpressen bzw. heißisostatischen Pressen des Verbundwerkstoffs auszufüllen. Sie dient in gewisser Weise auch dem Spannungsabbau. Gestrichelt in Fig. 8 dargestellt sind noch der Bauteilmantel 118 und eine Korrosionsschutzschicht 120 auf der Bauteiloberfläche.

Bei dem Entwurf für die Schichtenfolge, insbesondere für die duktile Verbundmatrixschicht 112, die hochwarmfeste Verbundmatrixschicht 114 und die duktile Verdichtungshilfeschicht 116 wird von den geforderten Eigenschaften des faserverstärkten Bauteils ausgegangen. Diese Forderungen zielen insbesondere auf eine Mindestzugfestigkeit $\sigma$, ein Mindest-E-Modul E und eine Mindestdehnung $\epsilon$ ab. Es sei angenommen, daß für diese drei Parameter bei Raumtemperatur und bei 800 °C folgende Werte vorgegeben sind:

|  | Raumtemperatur | 800 °C |
|---|---|---|
| $\sigma$ | 2 GPa | 1,5 GPa |
| E | 200 GPa | 150 GPa |
| $\epsilon$ | 1,3 % | 1,3 % |

Um bei einem Faseraufbau gemäß Fig. 8 die obigen Eigenschaften des Bauteils realisieren zu können, müssen, wie sich aus der Mischungsregel ergibt, die drei Schichten 112,114 und 116 bei 800 °C die nachfolgend angegebenen Werte für die Zugfestigkeit $\sigma$ und die Dehnung $\epsilon$ aufweisen:

| | duktile Verbundmatrixschicht 112 | hochwarmfeste Verbundmatrixschicht 114 | Verdichtungshilfeschicht 116 |
|---|---|---|---|
| $\sigma$ | 0,3 GPa | 0,53 GPa | 0,3 GPa |
| $\epsilon$ | 15 % | 2 % | 15 % |

Für die drei Schichten können damit folgende Titanbasis-Legierungen benutzt werden, um den Anforderungen genüge zu leisten:

duktile Verbundmatrixschicht 112: IMI 834 oder Ti1100

hochwarmfeste Verbundmatrixschicht 114: $\gamma$-TiAl (Ti-48Al-2Cr-2Nb)

Verdichtungshilfeschicht 116: IMI 834 oder Ti1100

Wie bereits oben kurz erwähnt, kommt der duktilen Verbundmatrixschicht 112 im hier diskutierten Beispiel die Aufgabe zu, intrinsische Spannungen, die aus unterschiedlichen Wärmeausdehnungskoeffizienten folgen, und extrinsische Spannungen, die z.B. aus unterschiedlichen E-Moduli folgen, abzubauen. Die Schicht 112 übernimmt ferner auch die Aufgabe der Rißausheilung bei Überbelastung. Die Schicht 112 sollte bei 900 °C eine hohe Duktilität aufweisen. Die hochwarmfeste Verbundmatrixschicht 114 hat zusammen mit der eigentlichen Faser die Aufgabe, bei 800 °C die mechanischen Belastungen zu tragen, denen das Bauteil ausgesetzt ist. Die Verdichtungshilfeschicht 116 sollte bei 800 °C wiederum hohe Duktilität aufweisen, um bei der Herstellung des Bauteils durch Heißpressen oder heißisostatisches Pressen bereits bei niedrigen Temperaturen eine gute Verbundkonsolidierung zu erzielen.

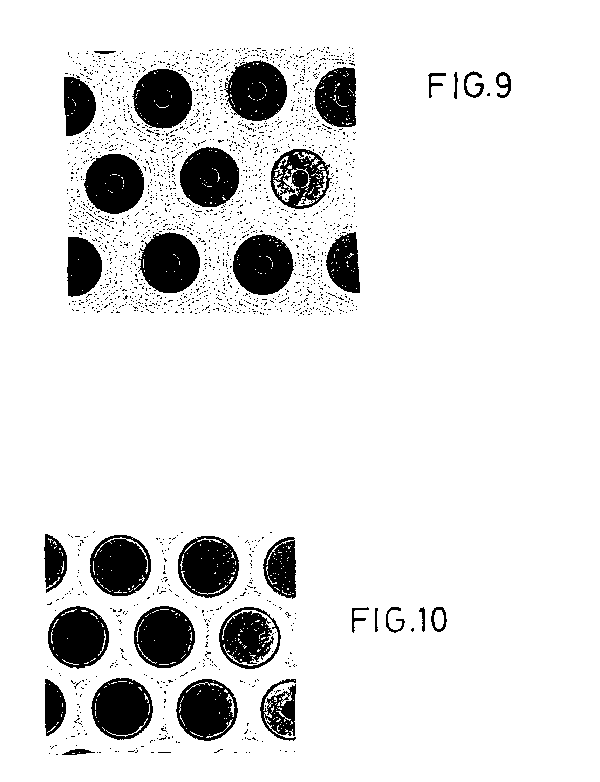

Nachfolgend soll noch anhand der zeichnerisch dargestellten Querschliffe der Fign. 9 und 10 auf den Aufbau eines faserverstärkten Bauteils, bei dem die einzelnen Fasern mehrere Schichten aufweisen, eingegangen werden. In Fig. 9 erkennt man konzentrisch um die eigentliche Faser herum angebrachte Phasen (Schichten), die durch eine Schichtenfolge mit wechselnder chemischer Zusammensetzung entstanden sind. Beim Heißpressen bzw. heißisostatischen Pressen werden diese Schichten zwar verformt, da bei diesen Vorgängen die Lücken zwischen den beschichteten Fasern aufgefüllt werden müssen, die Phasen bleiben aber an sich erhalten und können die ihnen beigemessenen und oben im einzelnen dargestellten unterschiedlichen Aufgaben übernehmen. Fig. 10 zeigt ein Beispiel für einen Verbund, bei dem auf die eigentliche Faser eine warmfeste, jedoch wenig duktile Schicht (Keramik oder intermetallische Verbindung) aufgebracht ist. Auf diese Schicht ist eine dünne, jedoch duktile Schicht aufgebracht, die während des Heißpreß- oder heißisostatischem Preßvorgangs die Lücken im Verbund schließt und so zu einer guten Verbundkonsolidierung führt.

## Patentansprüche

1. Vorrichtung zum Beschichten von mindestens eine Einzelfaser aufweisendem Fasermedium, mit
   - einer Trägervorrichtung zum Halten des zu beschichtenden mindestens eine Einzelfaser aufweisenden Fasermediums,
   - einer Sputtervorrichtung mit mehreren Beschichtungszonen zum Aufbringen von Beschichtungsmaterialien, und
   - einer Transportvorrichtung zum Transportieren des Fasermediums entlang eines Transportweges durch die Beschichtungszonen der Sputtervorrichtung zwecks sukzessiver Aufbringen mehrerer Lagen aus unterschiedlichem Beschichtungsmaterial auf das Fasermedium.

2. Vorrichtung nach Anspruch 1, gekennzeichnet durch
   - eine Abwickelvorrichtung für unbeschichtetes Fasermedium,
   - eine Aufwickelvorrichtung für Fasermedium nach der Beschichtung, wobei sich das Fasermedium zwischen der Abwickelvorrichtung und der Aufwickelvorrichtung erstreckt und dabei von der Transportvorrichtung durch die Beschichtungszonen der Sputtervorrichtung von der Abwickelvorrichtung zur Aufwickelvorrichtung transportierbar ist,
   - mehrere entlang einer geschlossenen gedachten Linie angeordnete Trägerkörper, an denen das Fasermedium punkt- oder linienweise gehalten ist, wobei das Fasermedium zwischen den Trägerkörpern freiliegt, und
   - ein an den Trägerkörpern ausgebildetes Führungssystem zum Führen des sich zwischen der Abwickelvorrichtung und der Aufwickelvorrichtung erstreckenden Fasermaterials an den Trägerkörpern während des Transports des Fasermaterials.

3. Vorrichtung nach Anspruch 2, dadurch gekennzeichnet, daß die Trägerkörper derart angeordnet und das Führungssystem derart ausgebildet ist, daß das Fasermedium schraubenlinienförmig mehrmals um die Anordnung von Trägerkörpern herumlegbar ist und dabei gehalten sowie beim Transport geführt ist.

4. Vorrichtung nach Anspruch 2 oder 3, dadurch gekennzeichnet, daß die Sputteranlage mehrere Paare von Targets aufweist, daß sich zwischen in Erstreckung des Fasermaterials aufeinanderfolgenden Trägerkörpern jeweils ein Paar von Targets der Sputteranlage radial innerhalb und radial außerhalb der gedachten Trägerkörper-Anordnungslinie befindet.

5. Vorrichtung nach Anspruch 4, dadurch gekennzeichnet, daß sich die Targets in axialer Richtung der schraubenlinienförmigen Anordnung des Fasermaterials über mehrere Windungen des Fasermaterials erstrecken.

6. Vorrichtung nach Anspruch 4 oder 5, dadurch gekennzeichnet, daß mehrere Paare von Targets in axialer Richtung der schraubenlinienförmigen Anordnung des Fasermediums aufeinanderfolgend angeordnet sind.

7. Vorrichtung nach Anspruch 6, dadurch gekennzeichnet, daß zwischen den jeweils nebeneinanderliegenden Targets zweier in axialer Richtung und/oder in Umfangsrichtung der schraubenlinienförmigen Anordnung des Fasermaterials aufeinanderfolgenden Paare von Targets jeweils eine Abschirmung angeordnet ist.

8. Vorrichtung nach Anspruch 7, dadurch gekennzeichnet, daß die Abschirmung mindestens einen Abschirmring aufweist.

9. Vorrichtung nach Anspruch 7, dadurch gekennzeichnet, daß die Abschirmung einen sich radial innerhalb und einen sich radial außerhalb der gedachten Trägerkörper-Anordnungslinie befindenden Abschirmring aufweist.

10. Vorrichtung nach einem der Ansprüche 4 bis 9, dadurch gekennzeichnet, daß die einander zugewandten Targets bereichsweise mit unterschiedlichen Beschichtungsmaterialien versehen sind.

11. Vorrichtung nach Anspruch 10, dadurch gekennzeichnet, daß die einzelnen Beschichtungsmaterialien innerhalb von Bereichen der Targets angeordnet sind, deren Form und Erstreckung in axialer Richtung des Fasermediums sowie in axialer Richtung der schraubenlinienförmigen Anordnung des Fasermaterials zur Erzielung einer Beschichtung mit einer vorgegebenen Folge von einzelnen Beschichtungslagen und einer vorgegebenen stofflichen Zusammensetzung gewählt sind.

12. Vorrichtung nach einem der Ansprüche 1 bis 11, dadurch gekennzeichnet, daß in Transportrichtung vor der ersten Beschichtungszone und/oder zwischen Beschichtungszonen eine oder mehrere Reinigungszonen der Sputtervorrichtung zum Reinigen des Fasermediums durch Sputtern angeordnet ist.

13. Vorrichtung nach einem der Ansprüche 1 bis 12, dadurch gekennzeichnet, daß die Trägervorrichtung (18) Trägerkörper (22) in Form von Trägerwellen aufweist, die entlang eines Kreisumfangs angeordnet sind, und daß das Führungssystem (26) eine Vielzahl von Umfangsvertiefungen (24) an den Trägerwellen aufweist.

14. Vorrichtung nach Anspruch 13, dadurch gekennzeichnet, daß die Umfangsvertiefungen (24) benachbarter Trägerwellen axial versetzt zueinander sind, wobei der Gesamtversatz über den gesamten Kreisumfang betrachtet gleich einem von der Ausgestaltung des Fasermediums (12) und dessen Anzahl an Einzelfasern abhängigen Vielfachen einer Umfangsvertiefung (24) ist.

15. Vorrichtung nach Anspruch 13 oder 14, dadurch gekennzeichnet, daß die Trägerwellen antreibbar sind, und zwar derart, daß sich ihre jeweils in Kontakt mit dem Fasermedium (12) befindlichen Umfangsflächenbereiche in Transportrichtung (42) des Fasermediums (12) bewegen.

16. Vorrichtung nach einem der Ansprüche 1 bis 15, dadurch gekennzeichnet, daß zwischen der Abwickelvorrichtung (14) und der Trägervorrichtung (18) und zwischen der Aufwickelvorrichtung (16) und der Trägervorrichtung (18) jeweils eine Fasermedium-Festhaltevorrichtung (64,66) zum nahezu gleitreibungsfreien Halten des Fasermediums (12) während dessen Transport angeordnet ist.

17. Vorrichtung nach Anspruch 16, dadurch gekennzeichnet, daß jede Fasermedium-Festhaltevorrichtung (64, 66) mit einer Rollenpaaranordnung versehen ist, die zwei federnd aneinanderliegende erste Rollen (68) und zwei federnd aneinanderliegende zweite Rollen (70) aufweist, wobei die ersten Rollen (68) in einer ersten Ebene und die zweiten Rollen (70) in einer zweiten Ebene angeordnet sind und wobei das Fasermedium (12) zwischen den ersten und den zweiten Rollen (68,70) hindurchführbar ist.

18. Vorrichtung nach einem der Ansprüche 1 bis 17, dadurch gekennzeichnet, daß eine relativ zu der Trägervorrichtung (18) bewegbare Mitnehmervorrichtung (46) zum Aufbringen des Fasermediums (12) auf die Trägervorrichtung (18) und zum Einlegen des Fasermediums (12) in das Führungssystem (26) vorgesehen ist, wobei das Fasermedium (12) an der Mitnehmervorrichtung (46) befestigbar ist.

19. Vorrichtung nach Anspruch 18, dadurch gekennzeichnet, daß die Mitnehmervorrichtung (46) von außen um die Anordnung von Trägerwellen herum bewegbar ist und dabei pro Umdrehung einen axialen Versatz erfährt, der ein von der Ausgestaltung des Fasermediums (12) und dessen Anzahl an Einzelfasern abhängiges Vielfaches einer Umfangsvertiefung (24) der Trägerwellen beträgt.

20. Vorrichtung nach Anspruch 19, dadurch gekennzeichnet, daß die Mitnehmervorrichtung (46) eine innerhalb der Anordnung von Trägerwellen angeordnete feststehende Spindel (48) mit Außengewinde (50) und einen mit der Spindel (48) in Gewindeeingriff stehenden drehbaren L-förmigen Auslegearm (58) aufweist, der radial nach außen über die Anordnung von Trägerwellen überragt und mit einem zu den Trägerwellen parallelen axialen Schenkel (59) versehen ist, an dessen freien Ende das Fasermedium (12) befestigbar ist, wobei die Steigung des Außengewindes (50) der Spindel (48) dem Gesamtversatz der Umfangsvertiefungen (24) der Trägerwellen über den gesamten Kreisumfang betrachtet entspricht.

21. Verfahren zum Beschichten von mindestens eine Einzelfaser aufweisendem Fasermedium, bei dem
    - das Fasermedium schraubenförmig angeordnet wird,
    - das unbeschichtete Fasermedium aus einer Vorratsvorrichtung entnommen wird, durch eine Beschichtungsvorrichtung mit mehreren Beschichtungszonen zum schichtweisen Aufbringen von unterschiedlichen Materialien hindurch transportiert wird und danach einer Speichervorrichtung für beschichtetes Fasermedium zugeführt wird,
    - das Fasermedium bei der Beschichtung in einer Schraubenlinienform mit mehreren Windungen gehalten wird, wobei sich das Fasermedium bei seinem Transport entlang der Schraubenlinienform bewegt, und
    - das sich entlang der Schraubenlinienform bewegende Fasermedium durch mehrere Beschichtungszonen hindurch transportiert wird, wobei sich die Beschichtungszonen über mehrere Windungen der Schraubenlinienform erstrecken.

22. Verfahren nach Anspruch 21, dadurch gekennzeichnet, daß das Fasermedium in Abhängigkeit von der Lage der Windung oder in Abhängigkeit von der Lage einer Gruppe von insbesondere aufeinanderfolgenden Windungen der Schraubenlinienform unterschiedlichen Beschichtungszonen oder unterschiedlichen Bereichen der Beschichtungszonen ausgesetzt wird, in denen unterschiedliche Materialien auf das Fasermedium aufgebracht werden.

23. Fasermedium für faserverstärkte Bauteile, mit
    - einer Faser aus Fasermaterial und
    - einer auf die Faser aufgebrachten Matrixbeschichtung aus Matrixmaterial,
    **dadurch gekennzeichnet,**
    - daß die Matrixbeschichtung eine erste Schicht (112) zum Abbau intrinsischer Spannungen zwischen Fasermaterial und Matrixmaterial und eine zweite Schicht (114) aufweist,
    - daß die erste Schicht (112) auf die Faser aufgebracht ist und aus einem duktilen Matrixmaterial besteht und
    - daß die zweite Schicht (114) auf die erste Schicht (112) aufgebracht ist und aus einem spröden und insbesondere hochwarmfesten Matrixmaterial besteht, welches insbesondere wesentlich spröder als das duktile Matrixmaterial der ersten Schicht (112) ist.

**24.** Fasermedium nach Anspruch 23, dadurch gekennzeichnet, daß die Matrixbeschichtung eine dritte Schicht (116) zum Ausfüllen von Zwischenräumen beim Verdichten benachbarter mit Matrixmaterial beschichteter Fasern aufweist, die auf die zweite Schicht (114) der Matrixbeschichtung aufgebracht ist und insbesondere wesentlich duktiler als das spröde Matrixmaterial der zweiten Schicht (114) ist.

**25.** Fasermedium für faserverstärkte Bauteile, mit
- einer Faser aus Fasermaterial und
- einer auf die Faser aufgebrachten Matrixbeschichtung aus Matrixmaterial,

**dadurch gekennzeichnet,**
- daß die Matrixbeschichtung eine zweite Schicht (114) und eine dritte Schicht (116) zum Ausfüllen von Zwischenräumen beim Verdichten benachbarter mit Matrixmaterial beschichteter Fasern aufweist,
- daß die zweite Schicht (114) aus einem spröden und insbesondere hochwarmfesten Matrixmaterial besteht und
- daß die dritte Schicht (116) aus einem duktilen Matrixmaterial besteht, welches insbesondere wesentlich duktiler als das spröde Matrixmaterial der zweiten Schicht (114) ist.

**26.** Fasermedium nach Anspruch 25, dadurch gekennzeichnet, daß die Matrixbeschichtung eine erste Schicht (112) zum Abbau intrinsischer Spannungen zwischen Fasermaterial und Matrixmaterial aufweist und daß die erste Schicht (112) aus einem Material besteht, das insbesondere wesentlich duktiler als das spröde Matrixmaterial der zweiten Schicht (114) ist.

**27.** Fasermedium nach einem der Ansprüche 23 bis 26, dadurch gekennzeichnet, daß zwischen dem Fasermaterial und der Matrixbeschichtung eine weitere Schicht (108) zur Steuerung der Haftung und Scherfestigkeit zwischen Fasermaterial und Matrixbeschichtung angeordnet ist.

**28.** Fasermedium nach einem der Ansprüche 23 bis 27, dadurch gekennzeichnet, daß zwischen dem Fasermaterial und der Matrixbeschichtung eine zusätzliche Schicht (110) als Diffusions- und Reaktionsbarriere angeordnet ist.

**29.** Fasermedium nach Anspruch 27 und 28, dadurch gekennzeichnet, daß die weitere Schicht (108) auf dem Fasermaterial, die zusätzliche Schicht (110) auf der weiteren Schicht (108) und die Matrixbeschichtung auf der zusätzlichen Schicht (110) angeordnet ist.

FIG.1

EP 0 669 406 A2

18

FIG.2

EP 0 669 406 A2

FIG.3

FIG.4

FIG.5

FIG.6

FIG.7

EP 0 669 406 A2

FIG.8

FIG.9

FIG.10